# EUROPEAN PATENT APPLICATION

(11) **EP 1 956 662 A2**
(43) Date of publication of application: **13.08.2008**
(21) Application number: 08100702.3
(22) Date of filing: 21.01.2008
(51) Int. Cl.: H01L 31/048, H01L 31/052

(54) **Encapsulated solar panel with lens**

(30) Priority: 09.02.2007 TW 96202518 U
(71) Applicant: Sin Guang Li International Co., Ltd., Nei Hu District Taipei City, Taiwan (CN)
(72) Inventor: Lin, Jung-Kan, Sin Guang Li International Co., Ltd., Taipei City (TW)
(74) Representative: Dossmann, Gérard

(57) **Abstract**

The present invention discloses an improved solar energy board, wherein a spherical lens (30) is formed on the sealing layer (28), which encapsulates the substrate (10) and the solar energy chips, to make the solar energy chips able to receive sunlight from any direction and promote the power output of the solar energy board.

## Description

The present invention relates to an improved solar energy board, particularly to a solar energy board with a spherical lens.

Solar energy is abundant, safe and zero-pollution and thus the best substitute energy while energy resources are being exhausted in the planet.

Solar energy is commonly converted into electric energy via optoelectronic semiconductor plates, i.e. the so-called solar energy board. The solar energy board receives sunlight and generates free electrons, and the movement of electrons forms current. However, a single solar energy board can only output very limited current. Thus, solar energy boards are usually connected in series or in parallel and packaged into a large-area solar energy board module. Although energy requirement can be satisfied via assembling solar energy board modules, the volume becomes too large, and the cost gets too high. Further, the solar energy board module should be rotated to track sunlight and receive sufficient solar energy. Thus, the investment of the rotation device is also needed in addition to that of modules and assemblage, which handicaps the popularization of solar energy.

Accordingly, the present invention proposes an improved solar energy board able to receive sunlight from any direction without using the rotation device.

The primary objective of the present invention is to provide an improved solar energy board, wherein a spherical lens is formed on the sealing layer of the solar energy board to make the solar energy chips able to receive sunlight from any direction, and the best efficiency of solar energy can thus be achieved without using a conventional solar tracker.

Another objective of the present invention is to provide an improved solar energy board, whereby a smaller system can output sufficient energy.

Yet another objective of the present invention is to provide an improved solar energy board, wherein the solar energy chips are applied onto the electrode wiring via a surface mount technology, and the design of the entire system can thus be more flexible.

Further another objective of the present invention is to provide an improved solar energy board, whereby the cost of solar energy is greatly reduced, and solar energy can be more easily accepted by people.

To achieve the abovementioned objectives, the present invention proposes an improved solar energy board, which comprises a substrate having a cathode wiring and an anode wiring; solar energy chips arranged on the substrate and electrically coupled to the cathode and the anode; a sealing layer covering the substrate and the solar energy chips; and a spherical lens formed on the sealing layer and receiving sunlight from any direction.

Below, the preferred embodiments are described in detail in cooperation with the drawings to make easily understood the characteristics and accomplishments of the present invention.
- Fig.1: is a front view of the improved solar energy board according to the present invention;
- Fig.2: is a top view of the improved solar energy board according to the present invention;
- Fig.3: is a side view of the improved solar energy board according to the present invention;
- Fig.4: is a bottom view of the improved solar energy board according to the present invention; and
- Fig.5: is a diagram schematically showing the wiring on substrate according to the present invention.

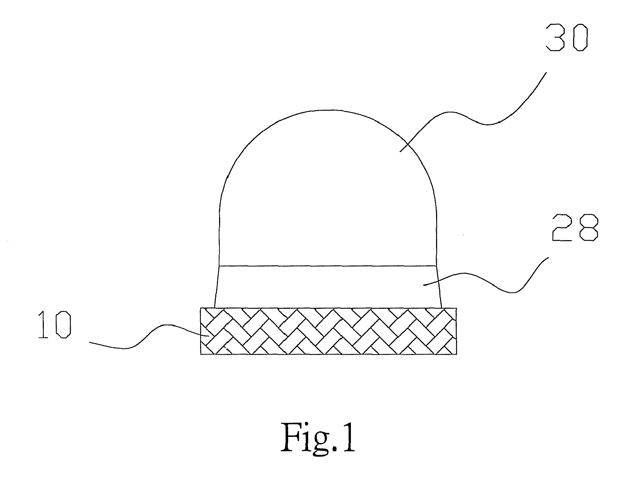

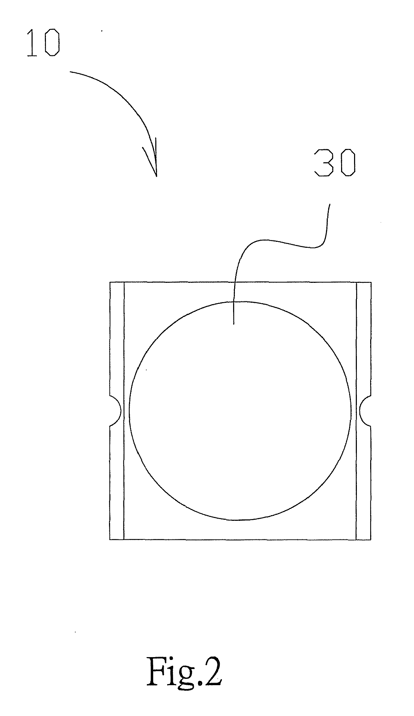

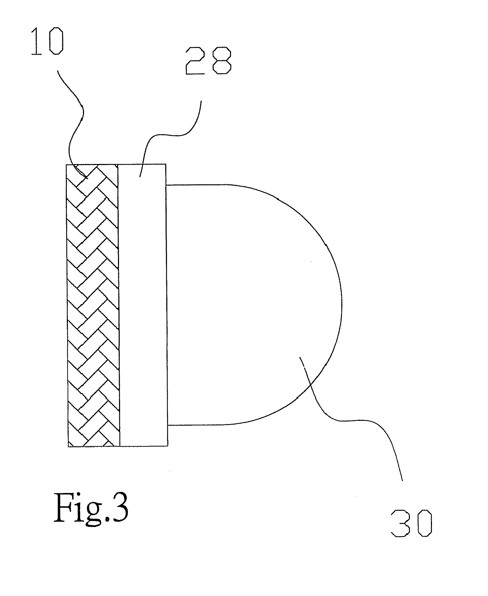

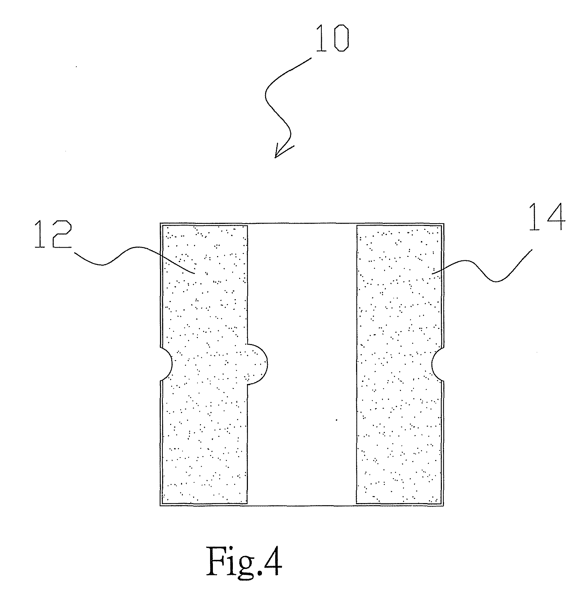

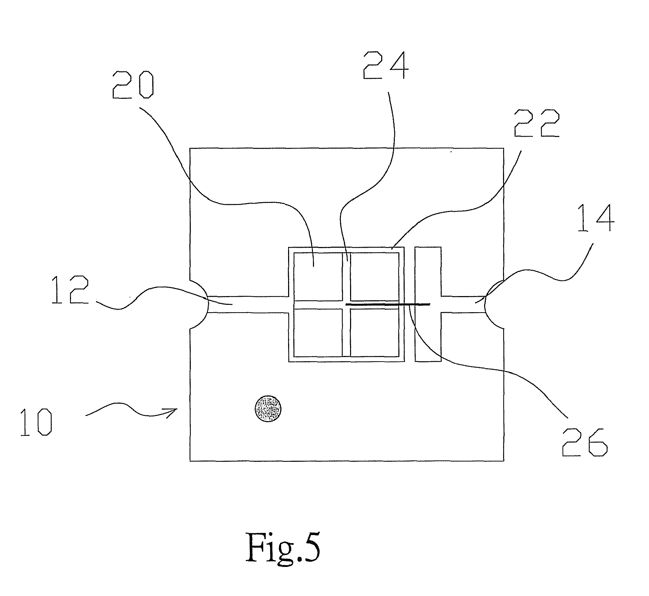

Refer to from Fig.1 to Fig.5 respectively a front view, a top view, a side view, a bottom view and a diagram of the wiring on substrate according to the present invention. The improved solar energy board of the present invention comprises a substrate 10, solar energy chips 20, a sealing layer 28 and a spherical lens 30. The substrate 10 may be made of alumina and has a cathode wiring 12 and an anode wiring 14. The cathode wiring 12 and the anode wiring 14 extend to the backside of the substrate 10 to form a cathode wiring terminal and an anode wiring terminal thereon. The solar energy chip 20 may be made of gallium nitride and is applied onto the front end of the cathode wiring 12 with an SMT (Surface Mount Technology) method. The front end of the cathode wiring 12 has a relatively-larger installation area 22 to facilitate the installation of the solar energy chips 20. Several metal wirings 24 are formed among the solar energy chips 20 (four (2x2) solar energy chips). The metal wirings 24 are electrically coupled to the front end of the anode wiring 14 via a metal wire 26. The front end of the anode wiring 14 is fabricated into a T shape to facilitate the wire-boding of the metal wirings 26 and the anode wiring 14. The sealing layer 28 is formed over the substrate 10 and the solar energy chips 20 to encapsulate the substrate 10, the solar energy chip 20, and the cathode wiring 12 plus the anode wiring 14, which are on the same face as the solar energy chips 20. The spherical lens 30 is arranged on the sealing layer 28 and can receive sunlight from any direction to make the solar energy chips 20 generate power.

In the present invention, a lmm-dimension solar energy board can output 0.5V power, and a 2mm-dimension solar energy board can output 2V power.

Via the spherical lens, the present invention can receive and fully harness the sunlight from all directions without using a solar tracker. Further, the solar energy board of the present invention is relatively smaller than the conventional one; thus, the solar energy board of the present invention can output more energy than the conventional one in a unit area. Therefore, the solar energy board of the present invention can apply to portable electronic devices, such as remote controllers, mobile phones, PDA (Personal Digital Assistant), GPS (Global Positioning System), etc.

Furthermore, the spherical lens-containing solar energy boards of the present invention can be combined together via modularized assemblage to afford greater power. Besides, the solar energy board of the present invention can cooperate with the batteries of the electronic device to provide power no matter whether there is light.

In conclusion, the present invention proposes an improved solar energy board, wherein a spherical lens is formed on the sealing layer of the solar energy board to make the solar energy chips able to receive sunlight from any direction and promote the efficiency of converting solar energy into electric energy. The present invention is free from the rotary elements of the solar tracker and uses much fewer solar energy chips. Therefore, the present invention can greatly reduce the cost of solar energy and popularize solar energy.

Those described above is only a preferred embodiment to exemplify the present invention. It is not intended to limit the scope of the present invention. Any equivalent modification or variation according to the shapes, structures, characteristics and spirit stated in the claims of the present invention is to be also included within the scope of the claims.

## Claims

1. An improved solar energy board, comprising the following components:
a substrate having a cathode wiring and an anode wiring;
at least one solar energy chip arranged on said substrate and electrically coupled to said cathode wiring and said anode wiring;
a sealing layer formed over one surface of said substrate to encapsulate said solar energy chip, said cathode wiring and said anode wiring on said surface; and
a spherical lens formed on said sealing layer and receiving sunlight from any direction.

2. The improved solar energy board according to claim 1, wherein said solar energy chip is applied to said wirings via a surface mount technology.

3. The improved solar energy board according to claim 1, wherein said solar energy chip is applied to said cathode wiring via a surface mount technology.

4. The improved solar energy board according to claim 3, wherein said solar energy chip is electrically coupled to said anode wiring via an electrically-conductive wire.

5. The improved solar energy board according to claim 1, wherein said sealing layer together with said spherical lens is a one-piece part.

6. The improved solar energy board according to claim 1, wherein said substrate is made of alumina.

7. The improved solar energy board according to claim 1, which applies to remote controllers, mobile phones, PDA (Personal Digital Assistant), and GPS (Global Positioning System).

8. The improved solar energy board according to claim 1, wherein said solar energy chip is made of gallium nitride.

9. The improved solar energy board according to claim 1, wherein front end of said anode wiring is fabricated into a T shape.

10. An improved solar energy board, comprising the following components:
a substrate having a cathode wiring and an anode wiring;
at least one solar energy chip arranged on front end of said cathode wiring and electrically coupled to said cathode wiring and said anode wiring;
a sealing layer formed over one surface of said substrate to encapsulate said solar energy chip, said cathode wiring, and said anode wiring on said surface ; and
a spherical lens formed on said sealing layer and receiving sunlight from any direction.

11. The improved solar energy board according to claim 10, wherein said solar energy chip is applied to said wirings via a surface mount technology.

12. The improved solar energy board according to claim 10, wherein said solar energy chip is electrically coupled to said anode wiring via an electrically-conductive wire.

13. The improved solar energy board according to claim 10, wherein said sealing layer together with said spherical lens is a one-piece part.

14. The improved solar energy board according to claim 10, wherein said substrate is made of alumina.

15. The improved solar energy board according to claim 10, which applies to remote controllers, mobile phones, PDA (Personal Digital Assistant), and GPS (Global Positioning System).

16. The improved solar energy board according to claim 10, wherein said solar energy chip is made of gallium nitride.

17. The improved solar energy board according to claim 10, wherein said the front end of said anode wiring is fabricated into a T shape.
